# EUROPEAN PATENT SPECIFICATION

(11) **EP 2 894 134 B1**
(45) Date of publication and mention of the grant of the patent: **25.05.2016**
(21) Application number: 14150634.5
(22) Date of filing: 09.01.2014
(51) Int. Cl.: C03C 17/00, C03C 17/245, C03C 17/36, C23C 14/00, C23C 14/34, C23C 14/35, C22C 14/00

(54) **Use of hafnium as dopant material for amplification of sputtering yield**
Verwendung von Hafnium als Dotiermittel zur Erhöhung der Abscheidungsrate
Utilisation d'hafnium en tant que matériau dopant pour l'amplification du rendement de pulvérisation

(43) Date of publication of application: 15.07.2015
(73) Proprietor: INTERPANE Entwicklungs-und Beratungsgesellschaft mbH, 37697 Lauenförde (DE)
(72) Inventor: Wagner, Dominik, 37671 Lüchtringen (DE); Kappertz, Oliver, 37077 Göttingen (DE); Weis, Hansjörg, 37671 Höxter (DE); Purwins, Michael, 37170 Uslar / Offensen (DE); Schmidt, Rüdiger M., 28213 Bremen (DE); Wuttig, Matthias, 52074 Aachen (DE)
(74) Representative: Körfer, Thomas

(56) References cited:
- WO-A2-2012/041499
- DE-B3- 10 333 619
- DE-B4-102005 038 139
- US-A- 5 415 756
- US-A1- 2006 051 597

## Description

The present invention relates to a sputtering technique for substrate coating, and more particularly to the use of a dopant for substrate coating.

Coating of substrates with thin films is a crucial issue in various technical fields. In the field of sheet glass, for example, products such as low-emissivity windows ("low-E windows"), antireflection windows, etc., as may be used, e.g., in double-pane window assemblies, comprise coatings which may comprise one or more layers of silver and metal oxides such as zinc oxide, tin oxide, or titanium dioxide, etc. Titanium dioxide may also further be used, for example, for windows with self-cleaning properties, etc..

Other coating applications relate to efficient photovoltaic solar cells, hardening tool bits, fabrication of data carriers such as CDs, DVDs, but also hard disks, etc..

Depositing a coating material on a substrate such as glass can include a sputtering process. At least one of the coating materials is provided in a target, which is bombarded by ions. As a result, particles such as atoms or ions of the coating material are ejected from the target and condense on the substrate.

The bombarding atoms or ions may be generated by, e.g., applying a DC voltage between the target and anode, and providing for a gas discharge of, e.g., an inert gas such as Neon etc.. Magnetron sputtering is a technique which includes provision of a magnetic field or fields to focus bombarding ions on or near the surface of the target. A reactive material such as a gas can be provided in a process chamber and can react, for example, with the ejected material on the target, in the process chamber, and/or on the substrate.

Sputtering yield amplification (SYA) comprises known techniques to increase a deposition rate on the substrate. It is intended to increase a yield of a given target material by providing a dopant such as a small concentration or impurity of another appropriate material on, at or near to the target surface.

EP 1 697 555 B1 describes a magnetron coating system comprising a first magnetron, an auxiliary substrate, and a second magnetron. The auxiliary substrate is arranged between the first magnetron and a region which is used to receive a substrate to be coated. A layer of metal is deposited on the auxiliary substrate by means of the first magnetron. The auxiliary substrate is used as a cathode for coating the substrate by means of the second magnetron. The system may be used for depositing a coating layer of titanium dioxide on a substrate.

DE 10 2005 038139 B4 and DE 103 33 619 B3 describe low-E coatings comprising a glass substrate coated with a titanium oxide layer doped with hafnium. The titanium oxide layers are formed by reactive magnetron sputtering

WO2012/041499 A2 describes glass substrates coated with doped titanium oxide layers for heat protection glazings. An examples of a dopant is tantalum. The doped titanium oxide layers are formed by reactive magnetron sputtering.

US 2006/051597 A1 describes glass substrates coated with doped titanium oxide layers. Examples of dopants are zinc, tin, niobium or tantalum. The doped titanium oxide layers are formed by reactive magnetron sputtering.

There is a need for a sputtering technique for substrate coating which optimizes deposition rates while minimizing any degradation of desired coating properties.

There is also a need for a sputtering process and/or an SYA process management which is configured to maximize deposition rates and achieve thereby a cost-efficient substrate coating, while at the same time any degradation of coating properties is minimized.

For example, there is a need for a cost-efficient technique of coating glass with titanium, wherein any degradation of a desired high refractive index of the titanium coating is minimized.

There is also a need for a sputtering technique for substrate coating which widens a range of available process options for optimizing a processing result for any particular appliance.

It is the object of the present invention to satisfy the above needs.

The object is solved by a use of a dopant according to claim 1

According to one aspect not according to the invention, a plant for coating a substrate via sputtering is discussed. The plant comprises a sputtering target providing a coating material for ejection during a sputtering process and deposition on the substrate. The plant is configured for the sputtering target providing, during the sputtering process, a dopant material for amplification of a sputtering yield. The dopant material is hafnium.

The plant may be configured for performing a coating in a laboratory and/or industrial environment. The substrate to be coated may comprise any kind of glass, such as sheet glass for windows, doors, balustrades, etc., solar panels or solar cells such as photovoltaic elements, solar heat elements or solar collector elements, semiconductor substrates such as wafers, circuit boards, circuitry including integrated circuits, data storage components such as hard discs, CDs, DVDs, tools and instruments including bits, pins and other cutting tools or other components to be hardened, etc..

The coating to be provided on the substrate may comprise a metal component such as titanium and/or silver and/or zinc and/or zirconium, etc. For example, coatings comprising titanium dioxide and/or zinc oxide and/or zirconium dioxide, etc. may be intended. The coating material may for example comprise titanium in the form of rutile or anatase.

The sputtering process may comprise one or more of the following techniques: DC ("direct current") sputtering, HF ("high frequency") / RF ("radio frequency") sputtering, reactive sputtering, gas flow sputtering, ion beam sputtering, magnetron sputtering including HiPIMS ("high power impulse magnetron sputtering"), etc. According to various embodiments, a sputtering target may be configured as a cathode of a magnetron.

The sputtering target may comprise one or more surface areas provided for impact of bombarding particles, which may be referred to as target areas, impact areas, and/or bombardment areas. The sputtering target may be provided as a support or carrier for the target surface such as a plate, massive or hollow rod, bar, role, bobbin, coil, cylinder, etc. The sputtering target may be configured as a fixed or rotating element of the plant. For example, the sputtering target may comprise a rotatable plate, rod or cylinder wherein a front end and/or a longitudinal side provide one or more impact areas. According to some embodiments, sputtering target such as a cylinder may comprise multiple target areas, wherein each area may be separately operable, for example for sputtering separate substrates or substrate areas in parallel.

According to various preferred embodiments, the sputtering target may be made entirely from the coating material, may comprise the coating material as an essential material, and/or may comprise at least a layer comprising essentially the coating material, wherein the term 'essentially' may generally be understood herein as the coating material contributing to a weight and/or volume of the target or layer to at least 70%, 80%, 90%, or more. According to some embodiments, the target may be made from titanium or a composition or compound comprising titanium, such as a titanium oxide. According to other embodiments, the target may serve as a carrier for a layer, e.g., an outer layer, comprising essentially titanium. According to some of these embodiments, the sputtering target may comprise a steel support or carrier such as a steel core, plate or rod with an outer or upper layer comprising essentially titanium.

Various preferred embodiments of the plant comprise a process chamber which may be adapted for providing 'vacuum conditions', to be understood as low pressure conditions as desired for a sputtering process. The process chamber may enclose the sputtering target and the substrate. The process chamber may be configured for containing, during the sputtering process, an inert gas for one or more of serving as a source for ion or atom bombardment of the target, adjusting a free wavelength for the particles ejected from the target, etc. The inert gas may for example comprise neon, argon, krypton, xenon, etc.

According to various preferred embodiments, the process chamber may be configured for containing a reactive gas during the sputtering process for reacting with the ejected particles before, during and/or after they being ejected from the target and/or being deposited on the substrate. The reactive gas may for example comprise one or more of the following: oxygen including molecular oxygen (O₂), air, nitrogen including molecular nitrogen (N₂), methane, etc.

Various approaches for deposition rate increase / sputter yield amplification (SYA) may be employed. According to some embodiments, there may be no dopant material present in or on the sputtering target, but may be present, for example, in an area above or otherwise near to a surface of the sputtering target. According to other preferred embodiments, the sputtering target may be prepared prior to employment in the or any sputtering process to permanently comprise dopant material, except from material ejected during the sputtering process or processes. For example, the target may be doped with the dopant material prior to the or any sputtering process. For example, dopant material may be present anywhere in, on and/or at the sputtering target, at one or more portions or sections of the sputtering target, etc. For example, the dopant material may form part of, be included, disposed or apportioned in a layer of the sputtering target establishing an impact area for particle bombardment.

According to various preferred embodiments, at least a portion of the sputtering target, such as a layer thereof, is formed of a target material, wherein the target material may comprise the dopant material and/or the coating material. For example, the sputtering target may comprise a layered structure related to a carrier, the coating material, and the dopant. For example, the sputtering target may comprise an outer layer of target material formed on an interior, inner or lower layer, a central or core part such as a carrier, rod or bar, etc. of the sputtering target, wherein the carrier may be made of any material which may or may not include the target material. For example, an outer layer of target material may be formed on a steel carrier or steel bar.

A portion or all of the target material may comprise a mixture of the coating material and the dopant material. The mixture may comprise any combination, composition or compound of both materials, neither excluding nor being restricted to a chemical composition of coating material and dopant material. Mass and/or volume ratios of coating material and dopant material may comprise any value according to the requirements of any specific sputtering process. For example, referring to mass and/or volume of the target material / the coating material, the dopant material may comprise up to 50%, up to 30%, up to 20%, or up to 10%, or less.

According to various preferred embodiments, the dopant material may have a distribution in, on or at the sputtering target which is different from a distribution of the coating material. For example, the coating material may be spread throughout the sputtering target, e.g. the target may be made of the coating material or a first layer of the target may be made of the coating material, and a second layer, e.g., an upper or outer layer of the sputtering target, may be made of or comprise the dopant material.

According to various preferred embodiments, the plant is configured for dopant material being provided to the sputtering target during the sputtering process. The dopant material provided during the sputtering process may serve to replenish dopant material previously provided prior to any sputtering process, in previous sputtering processes, and/or previously in the ongoing sputtering process. Alternatively, prior to the sputtering process there may be no dopant material on or in the sputtering target, or only small portions left over from a previous sputtering process.

Providing dopant material to the sputtering target during the sputtering process may comprise one or more of, for example, evaporation, ablation, spray deposition, or sputtering.

According to various embodiments, a magnetron is provided as a dopant source. The magnetron may be operated as an auxiliary or secondary magnetron in case the sputtering process for depositing the coating material on the substrate based on a main or primary magnetron configuration. One or both of the magnetrons may be operated with an alternating current (AC) / voltage for RF sputtering, for example with a frequency selected from within a range of 10 kilohertz (kHz) to 100 kHz. According to some embodiments, the main and the auxiliary magnetrons may be operated as a double magnetron.

According to one aspect of the invention, a method of coating a substrate via sputtering is proposed. The method comprises the steps of providing a sputtering target with a coating material, and performing a sputtering process wherein the coating material is ejected from the sputtering target and deposited on the substrate. The coating material may for example comprise titanium. For example, the coating material as deposited on the substrate may be titanium dioxide. The method may be employed for example for coating a substrate such as glass.

The sputtering target provides, during the sputtering process, a dopant material for amplification of a sputtering yield. The dopant material may be available on the sputtering target prior to the sputtering process, for example mixed with the coating material, and/or may be provided onto the target during the sputtering process.

The dopant material comprises hafnium. According to various preferred embodiments, when the dopant material comprises hafnium, the plant may be configured to achieve, during the sputtering process, a concentration of hafnium in the process chamber in the range of 2 - 8 atomic percent (at.%). Preferably, a concentration is between 2 - 5 at.%.

According to various embodiments, not according to the invention when the dopant material comprises tantalum, the plant may be configured to achieve, during the sputtering process, a concentration of tantalum in the process chamber in the range of 2 - 12 at.%, preferably between 2 - 5 at.%.

According to various other preferred embodiments, when the dopant material comprises tungsten, not according to the invention, the plant may be configured to achieve, during the sputtering process, a concentration of tungsten in the process chamber in the range of 2 - 9 at.%, preferably between 2 - 4 at.%.

According to one aspect of the invention, use of hafnium as a dopant material for amplification of a sputtering yield during a sputtering process for coating a substrate is proposed. The sputtering process includes that the coating material is ejected from the sputtering target and deposited on the substrate. A sputtering target with a coating material and the dopant is provided during the sputtering process.

One aspect of the invention is related to a glass which is coated with a coating of titanium dioxide. The coating comprises at least a small amount of hafnium, for example hafnium oxide (HfO₂). For example, a value of a ratio of hafnium to titanium by mass in the coating may be in the range of 1% to 10%, preferred between 1% and 8%, more preferred between 1% and 4%, even more preferred between 1% and 3%.

According to various preferred embodiments of the invention, a sputtering process includes a sputtering yield amplification based on a dopant material including hafnium. It turns out that for a coating material such as, e.g., titanium dioxide, use of the indicated substances as a dopant material enables increased deposition rates of the coating material. Consequently, deposition timescales may be shortened and costs per product unit be decreased. At the same time a degradation of properties of the coated substrate e.g., of the coating, can be minimized. For example, a refraction index of a coating for glass can be kept constant or nearly constant with a deviation of less than 10%. The proposed dopant materials provide for further process options available for optimizing a processing in terms of costs and desired product properties.

According to various preferred embodiments, the proposed dopant material may be used within the course of sputtering processes known as such, for example, DC, AC and/or magnetron sputtering, regarding, e.g., processing parameters such as employed coating material, controlling a sputtering process by, e.g., reactive gas flow, etc..

The proposed dopant material enables, for example, a cost-efficient coating of glass with, e.g., titanium dioxide with refractive properties as desired.

In the following, the invention will further be described by way of example with reference to exemplary embodiments illustrated in the drawings, in which:
- Fig. 1: schematically illustrates a coating plant according to a first embodiment of the invention;
- Fig. 2: schematically illustrates a coating plant according to a second embodiment of the invention;
- Fig. 3: schematically illustrates a coating plant according to a third embodiment of the invention;
- Fig. 4: is a flow diagram illustrating an operation of the coating plant according to Fig. 3;
- Fig. 5: schematically illustrates a preparation of a sputtering target for a sputtering process;
- Fig. 6: is a graph indicating experimental results for dopant materials employed in a sputtering process according to embodiments and comparative of the invention;
- Fig. 7: is a graph illustrating further experimental results for the dopant materials of Fig. 6;
- Fig. 8A: is a graph illustrating further experimental results for hafnium as a dopant material;
- Fig. 8B: is a graph illustrating further experimental results for tantalum not according to the invention as a dopant material; and
- Fig. 8C: is a graph illustrating further experimental results for tungsten not according to the invention as a dopant material.

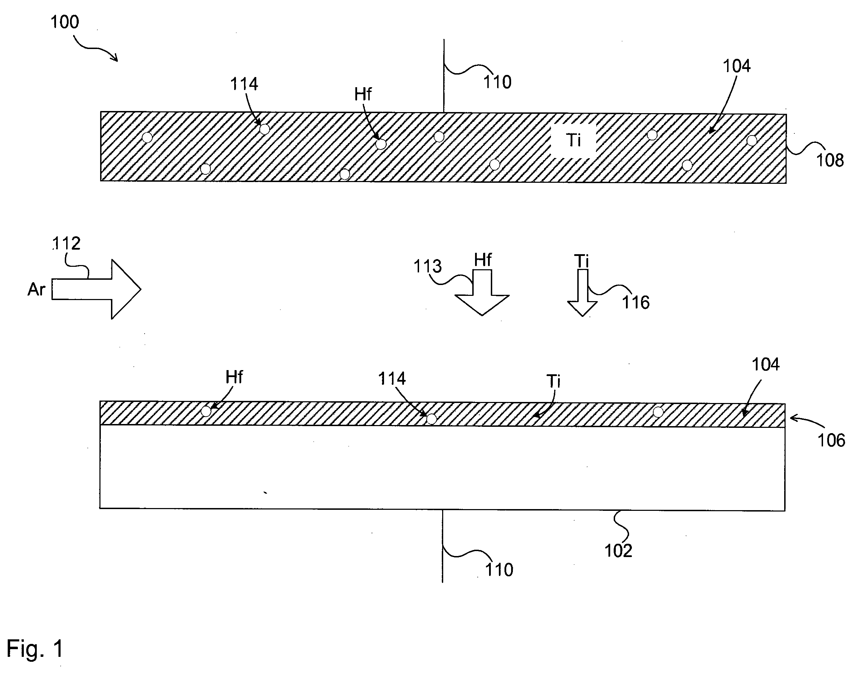

Fig. 1 schematically illustrates components of a coating plant 100 according to an embodiment of the invention. Plant 100 is configured for coating a substrate 102 via sputtering, wherein substrate 102 may exemplarily comprise sheet glass or architectural glass. Substrate 102 is intended to be coated with a coating material 104, which is assumed to be titanium (Ti) or compound thereof in the example described here. Portions or areas comprising the coating material 104 are depicted with hatching in Fig. 1. Further, Fig. 1 illustrates a situation wherein as a result of a sputtering process a coating layer 106 comprising the coating material 104 is already present on substrate 102.

Plant 100 comprises a sputtering target 108 for performing the sputtering process. For example, electrical circuitry 110 may be provided for arranging a DC-voltage and/or AC-voltage between target 108 and substrate 102. Arrow 112 indicates an inert gas such as argon (Ar) which provides ions for bombarding target 108. Other sputtering processes based on, e.g., ion beam bombardment can also be contemplated by the person of skill. As a result of the bombardment, particles of the coating material 104 are ejected from the target 108. The ejected particles move towards substrate 102 as indicated by arrow 113 and are deposited thereupon for forming the coating layer 106.

In the example illustrated in Fig. 1, the sputtering target 108 is essentially made of the coating material 104, i.e. titanium; specifically, the target 108 may essentially be made of titanium dioxide. However, the target 108 may be doped, i.e. a dopant material 114 be added. Portions or areas comprising the dopant material 114 are depicted with circlets in Fig. 1. The dopant material 114 is mixed with the coating material 104 throughout target 108, wherein 'mixing' may comprise a purely mechanical merging or blending and/or chemical composition of coating 104 and dopant 114 material. The dopant material 114 has been specifically selected according to its ability for amplifying a sputtering yield, i.e. enhancing a deposition rate of the coating material titanium 104 on the substrate 102. The dopant material 114 comprises hafnium.

As a result of ion bombardment, not only particles of the coating material titanium 104, but also particles of the dopant material hafnium 114 may be ejected from the target 108 during the sputtering process. Therefore, some of the dopant material hafnium (Hf) 114 may also be included in the coating layer 106 on substrate 102. For using the dopant material hafnium in a way as discussed with reference to the exemplary embodiment of Fig. 1, it has been surprisingly found that an advantageous sputtering process can be performed wherein a deposition rate of coating material can be significantly enhanced in comparison to a sputtering process without dopant or in comparison to other known dopants, while undesirable changes in coating layer properties can be minimized, as discussed in more detail below.

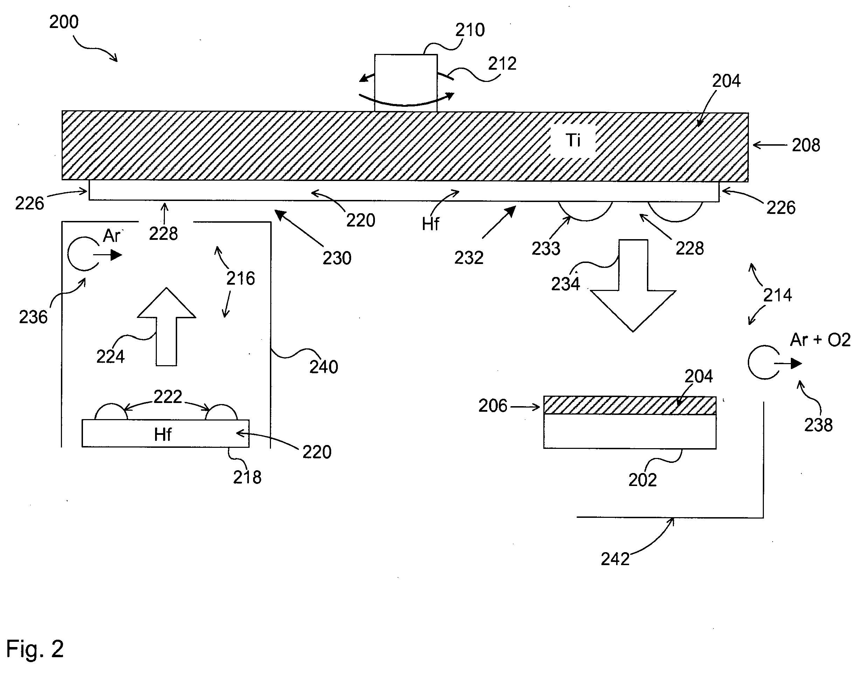

Fig. 2 illustrates components of a coating plant 200 according to another embodiment of the invention. Various aspects discussed with reference to Fig. 1 may similarly be applicable to the embodiment of Fig. 2 if not explicitly discussed or stated otherwise in the following. Plant 200 may be configured for coating a substrate 202 via sputtering, wherein substrate 202 may again exemplarily comprise glass. Substrate 202 is intended to be coated with a coating material 204 the presence of which in an area is indicated by hatching thereof in Fig. 2. The coating material may again comprise titanium (Ti). During the sputtering process illustrated in Fig. 2, a coating layer 206 has already been formed by depositing coating material titanium 204 on substrate 202.

A sputtering target 208 is provided which is made of the coating material titanium 204. As indicated by shaft 210 and arrows 212, target 208 may be rotatably supported during a sputtering process. Plant 200 is configured for performing a magnetron sputtering. Accordingly, the sputtering target 208 is embodied as a cathode. Specifically, target 208 may be provided as a planar cathode in the form of a flat carrier or plate. The magnetron configuration / sputtering process 214 may be operated 238 with an inert gas such as argon and a reactive gas such as oxygen O₂, which may support forming the coating layer 206 of titanium oxide (TiOₓ). A process chamber 242 encloses sputtering target 208, substrate 202 and provides a process volume for reactions such as between ejected titanium Ti particles and the reactive gas O₂.

Besides main or primary magnetron configuration 214, plant 200 comprises a separate, auxiliary or secondary magnetron configuration 216 including an auxiliary or secondary cathode 218. The cathode 218 may be made of or may at least comprise a dopant material 220. In the example described here, the dopant material 220 comprises hafnium.

The auxiliary sputtering process / magnetron configuration 216 may be operated purely with an inert gas such as argon (Ar) 236. In order to separate the pure inert gas atmosphere of configuration 216 from the inert & reactive atmosphere of configuration 214, for example a separating process chamber 240 may be provided. The magnetron configuration 216 may be operated to eject dopant material 220, as schematically indicated by ejection / evaporation areas 222, wherein some of the ejected material 220 will be deposited on the sputtering target 208, as indicated by arrow 224. The deposited dopant material 220 may form a layer 226 in an area 228 of planar target 208 when area 228 is at a position 230.

Due to appropriate rotation 212 of plate-like target 208, area 228 moves to position 232 near to, i.e. facing, substrate 202. In position 232, layer 226 of dopant material 220 in area 228 is involved in the magnetron configuration 214. More specifically, an ejection from target 208 and deposition of coating material titanium 204 on the substrate 202 is indicated by evaporation areas 233 and arrow 234, respectively. Dopant material hafnium 220 in layer 226 of area 228 is involved in SYA, i.e. enhancing the deposition rate 234.

Similar to particles of the coating material titanium 204 ejected from target 208, also particles of the dopant material hafnium 220 are ejected from layer 226 in position 232 during a sputtering process as a result of ion bombardment. Some of the dopant material hafnium 220 may therefore also be included in the coating layer 206 on substrate 202. Similarly as has been discussed for the example embodiment of Fig. 1, using as dopant material hafnium leads to significantly increased deposition rates with marginal changes in coating layer properties only.

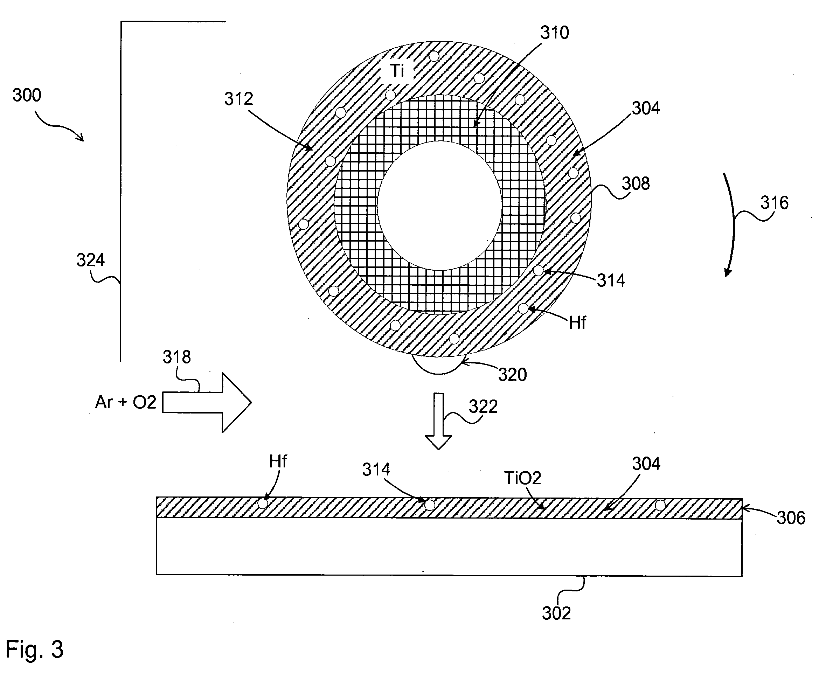

Fig. 3 illustrates components of a coating plant 300 according to still another embodiment of the invention. It is again exemplarily assumed that a substrate 302 to be coated may comprise glass.

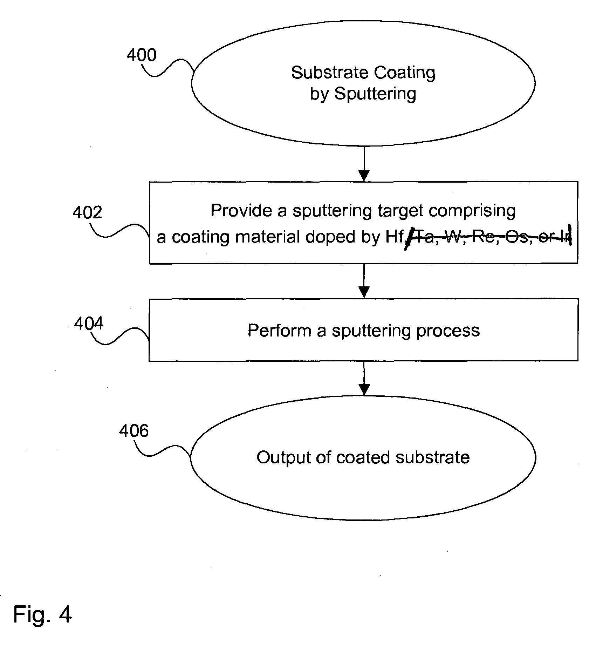

An operation 400 of coating plant 300 for coating a substrate 302 via sputtering will be described with reference to the flow diagram in Fig. 4. In step 402, a sputtering target 308 with a coating material 304 is provided. Specifically, the coating material 304 may comprise titanium (Ti). A hatching in Fig. 3 indicates an area or areas comprising the coating material titanium 304. The sputtering target 308 comprises a hollow cylinder 310 made of, for example, steel and carrying an outer layer 312 of target material, wherein the target material comprises the coating material titanium 304 and as an additive or admixture a dopant material 314. The dopant material 314 comprises hafnium (Hf). Circlets indicate in Fig. 3 an area or areas comprising the dopant material hafnium 314.

In step 404, a sputtering process is performed wherein coating material 304 is ejected from the sputtering target 308 and deposited on the substrate 302. A coating layer 306 is formed on substrate 302 during the sputtering process'.

Specifically, during the sputtering process an inert gas such as argon (Ar) may be supplied as indicated by arrow 318. Plant 300 may be arranged for DC sputtering, magnetron sputtering, RF sputtering, etc.. During the sputtering process, target cylinder 308 may rotate as indicated by arrow 316. Area 320 indicates an ejection of particles of the target material 312 from sputtering target 308 as a result of the sputtering process.

Gas supply 318 may additionally comprise a reactive gas such as oxygen (O₂) which reacts with at least some of the ejected particles to form, for example, a titanium oxide (TiOₓ). As indicated by arrow 322, at least part of the reacted particles move towards substrate 302 to form the coating layer 306 comprising TiOₓ particles. A process chamber 324 encloses sputtering target 308, substrate 302 and provides a process volume for reactions such as between ejected particles and the reactive gas.

In order to significantly enhance a deposition rate of the coating material 304 onto substrate 302 during the sputtering process, the dopant material hafnium 314 is admixed to the coating material titanium 304 to form the target material 312 of sputtering target 308. As a result of the sputtering process, also hafnium particles move 322 towards substrate 302, and the coating layer 306 may contain a small amount of hafnium (Hf) particles.

The configuration of Fig. 3 refers to a sputtering target provided in advance with a desired target stoichiometry, i.e. a target material including coating material and dopant material as desired. This does not exclude an in-situ variation of an impact area during the sputtering process, such as a replenishment of dopant material, for example by an auxiliary magnetron configuration similar to what is illustrated in Fig. 2, or any other process.

In step 406 the coating process 400 terminates, for example when a desired batch of sheet glass has been coated with a coating layer of desired width and/or consistency in order to achieve one or more desired optical properties. The coated product may then be provided for further steps of manufacturing, storing, etc.

Similarly as has been discussed for the example embodiments of Figs. 1 and 2, using the dopant material hafnium in process 400 can lead to significantly increased deposition rates with marginal changes in coating layer properties only.

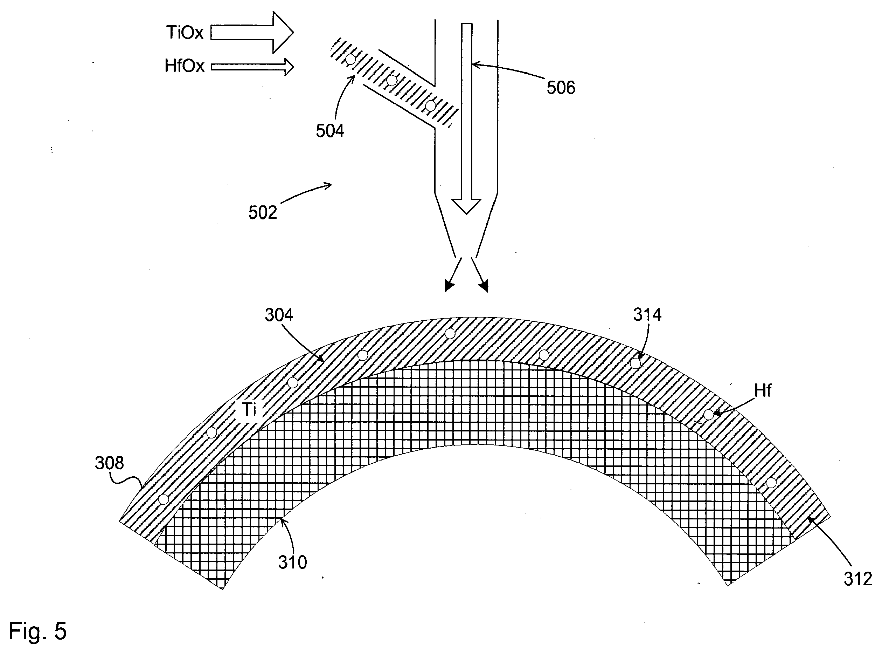

Fig. 5 schematically illustrates a process of preparing sputtering target 308 of Fig. 3 for use in the coating process 400 of Fig. 4. Various approaches are known to those of skill in the field which may be applied for providing the layer of appropriately doped target material 312 on an outer surface of steel torso 310 of target 308. Exemplarily, a burner 502 is illustrated which burns a powder 504 by means of a gas flow 506 and the evaporation is conveyed via nozzle 508 towards torso 310 to form layer 312 thereupon.

The powder 504 may comprise the intended coating material titanium admixed with the intended dopant material hafnium. Specifically, for example titanium oxide (TiOₓ) powder such as one or more of TiO, TiO₂, Ti₂O₃, etc. may be mixed with hafnium oxide (HfOₓ) powder, e.g. one or both of hafnium oxide (HfO) and hafnium dioxide (HfO₂). The powder mixture may also be compressed to form a rod or wire before being supplied to burner 502.

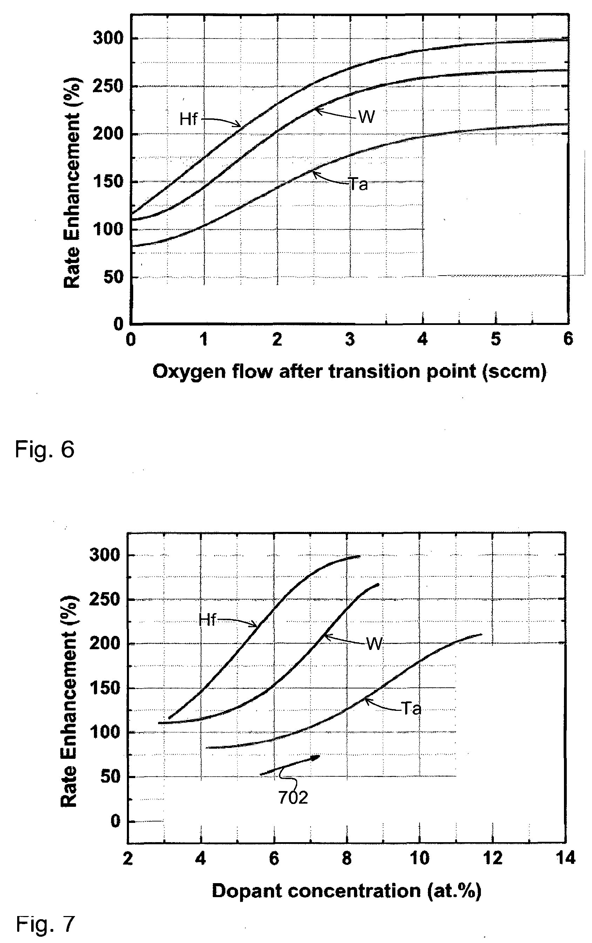

Fig. 6 illustrates experimental results for coating a glass substrate with titanium dioxide when using sputtering processes including SYA with and without various dopant materials. Results such as those presented in Fig. 6 may be obtained, for example, when using a coating plant similar to plant 200 of Fig. 2.

Specifically, Fig. 6 depicts deposition rate enhancements for various dopant materials in percent (%) as compared to a deposition rate without any dopant material. The rate enhancement is indicated as a function of oxygen flow in units of sccm (standard cubic centimeters per minute); more precisely, an oxygen flow after a transition point is indicated wherein this type of diagram is known to the skilled person. A current flowing in the magnetron configuration 214 (see Fig. 2) between sputtering target and substrate is kept constant.

Results for hafnium (Hf), tantalum Ta (not according to the invention), and tungsten (W) (not according to the invention) are depicted in Fig. 6. Near to the transition point, a rate enhancement of tantalum (not according to the invention) is of the order of 80%, while with tungsten a rate enhancement of the order of 115% can be achieved. Surprisingly, employing hafnium as a dopant enables a rate enhancement of the order of 120%, i.e. a rate enhancement which is of the order of or even larger than that of tungsten. The results persist for increasing oxygen supply. The measured rate enhancements monotonically increase for all three dopants and reach a saturation level of about 210% for tantalum, about 260% for tungsten, and near to 300% for hafnium.

In these experiments, a supply rate, e.g. via auxiliary magnetron configuration 216 (Fig. 2) and then for example measured in nanometers per hour, may be as follows: Referenced to a supply rate of tungsten, a supply rate of tantalum may be increased by a factor of 1.35, while a supply rate of Hf may be increased by a factor of 1.90.

Fig. 7 depicts other experimental results which may have been achieved with a similar setup as described above for the results illustrated of Fig. 6. Rate enhancements in percent (%) are indicated as a function of dopant concentration in a process volume, for example in a process chamber enclosing the magnetron configuration 214 in Fig. 2. The dopant concentration is given in atomic percent (at.%). Arrow 702 roughly indicates a direction of increasing oxygen flow.

Results for hafnium (Hf), tantalum (Ta) (not according to the invention,) and tungsten (W) (not according to the invention) are depicted. A rate enhancement for tantalum Ta at about 2 - 5 at.% is about 80%, is slowly increasing for increasing concentrations and reaches about 210% at concentrations of about 12 at.%.

A rate enhancement for tungsten (not according to the invention) at about 2 - 4 at.% is about 115% - 120% with a moderately steep increase for increasing concentrations and reaching about 260% at concentrations of about 9 at.%.

Surprisingly, a rate enhancement for hafnium at about 2 - 5 at.% is about 120 % to 140% with a steep increase for increasing concentrations and reaching about 300% at concentrations of about 8 at.%.

As a further experimental result it is noted that when using hafnium as a dopant material in a magnetron sputtering configuration with constant current control, a target voltage tends to be lower compared to similar configurations using tungsten, tantalum, or other chemical elements of the 6^{th} period of the periodic table including, for example, lead (Pb) and bismuth (Bi). The lower target voltage for hafnium as dopant material may be considered to increase a surface escape energy required for particles to escape the sputtering target surface for being ejected therefrom. This may contribute to differences in behaviour of hafnium vs. other dopants such as tungsten or tantalum.

Theoretical considerations including simulations of, for example, deposition rate enhancements for elements of the 6^{th} row of the periodic table from hafnium to bismuth as dopant material in an aluminum target are not generally in good agreement with the results presented above for a titanium target. Theoretical results tend to indicate, for example, significant rate enhancements for lead and bismuth, which surprisingly appears not in fact to be the case. Theoretical results do further not indicate a particularly significant rate enhancement for hafnium, although that being in fact the case.

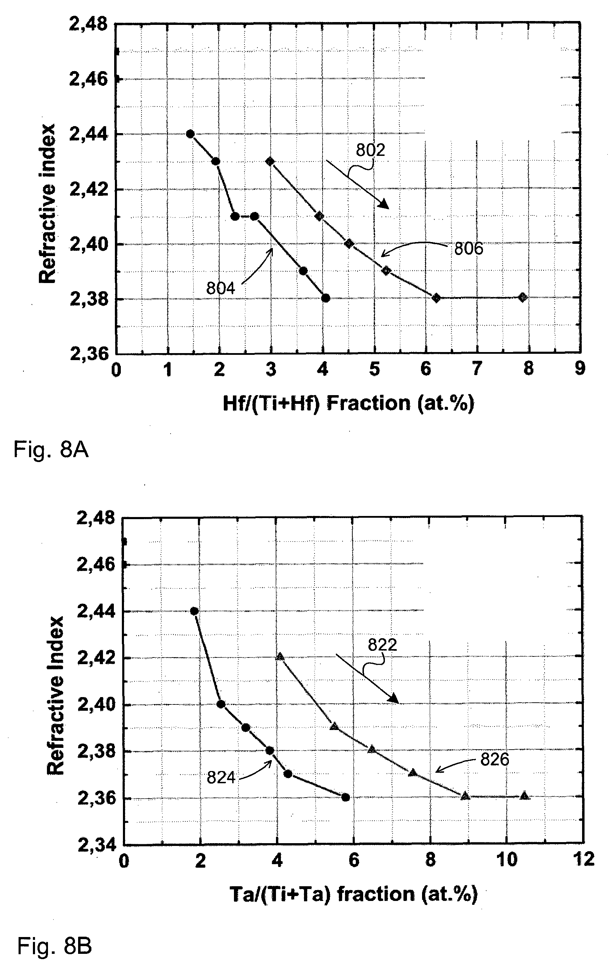

Fig. 8A indicates further experimental results which may have been achieved with the same setup as described above for Figs. 6 and 7. A refractive index resulting from a titanium dioxide TiO₂ coating with hafnium as a sputtering dopant is indicated as a function of relative mass fraction Hf / (Ti+Hf) in a sputtering process volume in atomic percent (at.%). Arrow 802 indicates a direction of increasing oxygen (O₂) flow when performing the experiments.

Data sets 804 and 806 result from different concentrations of the dopant material hafnium as provided by an auxiliary magnetron configuration such as configuration 216 of Fig. 2. The specific values for dopant concentration have been reasonably selected for SYA purposes, i.e. to achieve reasonable deposition rates while minimizing potential adverse influences on coating properties. While the specific values as measured, for example, in nanometer per hour, are somewhat arbitrary, in general a concentration of the dopant material hafnium is of order twice for the data set 806 as compared to data set 804. The exemplary values for a given specific experimental configuration similar to that depicted in Fig. 2 comprise evaporation rates of 49 nanometer per hour (nm/h) for data set 804 and 99 nm/h for data set 806.

As depicted in Fig. 8A, the effect of using hafnium as dopant material generally has only a minor influence on the refractive index. The largest measured effects for reasonable concentrations of the dopant material and oxygen flow comprise a reduction in refractive index from 2.47 to 2.38, i.e. a relative reduction of 3.6 %. For low mass fractions in the range of 1 - 3 at.%, the effects are even less and can be restricted to a reduction from 2.47 to about 2.41, i.e. a reduction of the order of 2.4 % when using smaller concentrations of dopant material.

Fig. 8B indicates experimental results which have been established in a similar way as has been described for Fig. 8A. A refractive index resulting from a titanium oxide TiOₓ coating of glass with tantalum (Ta) (not according to the invention) as a sputtering dopant is indicated as a function of relative mass fraction Ta / (Ti+Ta) in a sputtering process volume in atomic percent (at.%). Arrow 822 indicates a general direction of increasing oxygen (O₂) flow.

Data sets 824 and 826 result from different reasonable concentrations of the dopant material tantalum (not according to the invention). A concentration of the dopant material tantalum is of order twice for the data set 826 as compared to data set 824. More specifically, an experimental configuration was employed similar to that underlying the results of Fig. 8A. The evaporation rates selected for tantalum were 35 nm/h for data set 824 and 70 nm/h for data set 826.

The effect of using tantalum (not according to the invention) as dopant material has a slightly larger influence on the refractive index as compared to using hafnium. However, the largest measured effects are a reduction in index from 2.47 to 2.36, i.e. a relative reduction of order 4.5 %. The effect can be restricted to about 3.6 % for low mass fractions in the range of 1 - 4 at.%, i.e. smaller concentrations of dopant material.

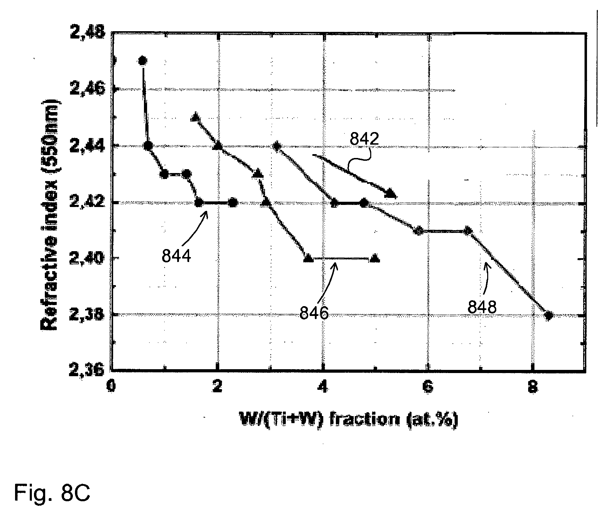

Fig. 8C indicates experimental results which have been established in a similar way as has been described for Figs. 8A and 8B. A refractive index resulting from a titanium oxide (TiOₓ) coating of glass with tungsten (W) (not according to the invention) as a sputtering dopant is indicated as a function of relative mass fraction W / (Ti+W) in a sputtering process volume in atomic percent (at.%). Arrow 842 indicates a general direction of increasing oxygen (O₂) flow.

Data sets 844, 846 and 848 result from different appropriate concentrations of the dopant material tungsten (not according to the invention) on or in the sputtering targe Generally, a concentration of the dopant material tungsten (not according to the invention) is of order twice for the data set 846 when compared to data set 844, and of order twice for the data set 848 when compared to data set 846. As exemplary values selected in a similar specific experimental configuration as used for obtaining the results depicted in Figs. 8A and 8B, the evaporation rates are 13 nm/h for data set 844, 26 nm/h for data set 846, and 52 nm/h for data set 848.

The effect of using tungsten as a dopant material (not according to the invention) has a slightly larger influence on the refractive index as compared to using hafnium. However, the largest measured effects are a reduction in index from 2.47 to 2.38, i.e. a relative reduction of order 3.6%. The effect can be restricted to about 1.6% for low mass fractions in the range of 1 - 4 at.%, i.e. correspondingly small concentrations of dopant material on or in the target.

As described above, when a sputtering process is performed near to a transition point to limit an oxygen flow, the impact on a desired refractive index can be kept well below 10%, and even below 5%, while nevertheless remarkably high deposition rate enhancements of the order of 100% and more can be achieved for hafnium . In this way, various new process options are provided for substrate coating via sputtering.

While the invention has been described in relation to its preferred embodiments, it is to be understood that this description is intended non-limiting and for illustrative purposes only. In particular, various combinations of features wherein the features have been described separately hereinbefore are apparent as advantageous or appropriate to the skilled artisan. Accordingly, it is intended that the invention be limited only by the scope of the claims appended hereto.

## Claims

1. Use of hafnium as a dopant material (114, 220, 314) for amplification of a sputtering yield during a sputtering process for coating a substrate (102, 202, 302), wherein a sputtering target (108, 208, 308) with a coating material (104, 204, 304) and the dopant material (114, 220, 314) is provided during the sputtering process which includes that the coating material (104, 204, 304) is ejected from the sputtering target (108, 208, 308) and deposited on the substrate (102, 202, 302).

2. The use according to claim 1,
wherein the coating material (104) comprises titanium.

3. The use according to claim 1 or 2,
wherein the substrate (102) comprises glass.

4. The use according to any of the preceding claims,
wherein the sputtering process is performed in a process chamber (242, 324) configured for containing at least one of an inert gas and a reactive gas, the inert gas comprising at least one of argon, krypton and/or xenon, and the reactive gas comprising at least one of oxygen and/or nitrogen.

5. The use according to any of the preceding claims,
wherein the sputtering target (208, 308) comprises a layered structure related to a carrier (310), the coating material (312) and/or the dopant (226).

6. The use.according to claim 5,
wherein the carrier (310) comprises a rotatable steel core.

7. The use according to claim 5 or 6,
wherein the sputtering target (308) comprises a layer of target material (312), the target material comprising a mixture of the coating material (304) and the dopant material (314).

8. The use according to any of the preceding claims, wherein the dopant material (220) is provided to the sputtering target (208) during the sputtering process.

9. The use according to claim 8,
wherein a main magnetron configuration (214) comprises at least one of the sputtering target (208) and the substrate (202), and an auxiliary magnetron configuration (216) is provided as a dopant (220) source.

10. The use according to claim 1,
wherein during the sputtering process a concentration of hafnium in a process chamber (324) is controlled in a range of 2 - 8 at.%, preferably between 2 - 5 at.%.

## Patentansprüche

1. Verwendung von Hafnium als Dotierungsmaterial (114, 220, 314) zur Vergrößerung einer Zerstäubungsausbeute während eines Zerstäubungsprozesses zum Überziehen eines Substrats (102, 202, 302), wobei ein Zerstäubungs-Target (108, 208, 308) mit einem Überzugsmaterial (104, 204, 304) und dem Dotierungsmaterial (114, 220, 314) während des Zerstäubungsprozesses bereitgestellt wird, der einschließt, dass das Überzugsmaterial (104, 204, 304) aus dem Zerstäubungs-Target (108, 208, 308) ausgetrieben und auf dem Substrat (102, 202, 302) niedergeschlagen wird.

2. Verwendung nach Anspruch 1,
wobei das Überzugsmaterial (104) Titan umfasst

3. Verwendung nach Anspruch 1 oder 2,
wobei das Substrat (102) Glas umfasst.

4. Verwendung nach einem der vorhergehenden Ansprüche,
wobei der Zerstäubungsprozess in einer Prozesskammer (242, 324) ausgeführt wird, die gestaltet ist, um zumindest eines von einem Edelgas und einem reaktiven Gas zu enthalten, wobei das Edelgas zumindest eines von Argon, Krypton und/oder Xenon umfasst und wobei das reaktive Gas zumindest eines von Sauerstoff und/oder Stickstoff umfasst.

5. Verwendung nach einem der vorhergehenden Ansprüche,
wobei das Zerstäubungs-Target (208, 308) einen Schichtenaufbau in Bezug auf einen Träger (310), das Überzugsmaterial (312) und/oder den Dotierungsstoff (226) umfasst.

6. Verwendung nach Anspruch 5,
wobei der Träger (310) einen drehbaren Stahlkern umfasst.

7. Verwendung nach Anspruch 5 oder 6,
wobei das Zerstäubungs-Target (308) eine Schicht aus einem Target-Material (312) umfasst, wobei das Target-Material ein Gemisch aus dem Überzugsmaterial (304) und dem Dotierungsmaterial (314) umfasst.

8. Verwendung nach einem der vorhergehenden Ansprüche,
wobei das Dotierungsmaterial (220) für das Zerstäubungs-Target (208) während des Zerstäubungsprozesses bereitgestellt wird.

9. Verwendung nach Anspruch 8,
wobei eine Haupt-Magnetronanordnung (214) zumindest eines von dem Zerstäubungs-Target (208) und dem Substrat (202) umfasst und wobei eine Hilfs-Magnetronanordnung (216) als Dotierungsquelle (220) vorgesehen ist.

10. Verwendung nach Anspruch 1,
wobei eine Konzentration von Hafnium während des Zerstäubungsprozesses in einer Prozesskammer (324) in einem Bereich von 2-8 At. %, vorzugsweise zwischen 2-5 At.% gesteuert wird.

## Revendications

1. Utilisation d'hafnium comme un matériau dopant (114, 220, 314) pour amplification d'un rendement de pulvérisation pendant un procédé de pulvérisation pour le revêtement d'un substrat (102, 202, 302), dans laquelle une cible de pulvérisation (108, 208, 308) avec un matériau de revêtement (104, 204, 304) et le matériau dopant (114, 220, 314) est fournie pendant le procédé de pulvérisation qui inclut que le matériau de revêtement (104, 204, 304) est éjecté de la cible de pulvérisation (108, 208, 308) et déposé sur le substrat (102, 202, 302).

2. Utilisation selon la revendication 1,
dans laquelle le matériau de revêtement (104) comprend du titane.

3. Utilisation selon la revendication 1 ou 2,
dans laquelle le substrat (102) comprend du verre.

4. Utilisation selon l'une quelconque des revendications précédentes,
dans laquelle le procédé de pulvérisation est réalisé dans une chambre de procédé (242, 324) configurée pour contenir au moins un d'un gaz inerte et d'un gaz réactif, le gaz inerte comprenant au moins un d'argon, crypton et/ou xénon, et le gaz réactif comprenant au moins un d'oxygène et/ou d'azote.

5. Utilisation selon l'une quelconque des revendications précédentes,
dans laquelle la cible de pulvérisation (208, 308) comprend une structure en couches liée à un support (310), le matériau de revêtement (312) et/ou le dopant (226).

6. Utilisation selon la revendication 5,
dans lequel le support (310) comprend un noyau en acier rotatif.

7. Utilisation selon la revendication 5 ou 6,
dans lequel la cible de pulvérisation (308) comprend une couche de matériau cible (312), le matériau cible comprenant un mélange du matériau de revêtement (304) et du matériau dopant (314).

8. Utilisation selon l'une quelconque des revendications précédentes,
dans laquelle le matériau dopant (220) est fourni à la cible de pulvérisation (208) pendant le procédé de pulvérisation.

9. Utilisation selon la revendication 8,
dans laquelle une configuration de magnétron principal (214) comprend au moins un de la cible de pulvérisation (208) et du substrat (202), et une configuration de magnétron auxiliaire (216) est fournie comme une source de dopant (220).

10. Utilisation selon la revendication 1,
dans laquelle pendant le procédé de pulvérisation une concentration en hafnium dans une chambre de procédé (324) est contrôlée dans un intervalle de 2-8 % at, de préférence entre 2-5 % at.
